# EUROPÄISCHE PATENTANMELDUNG

(11) **EP 0 863 530 A2**
(43) Veröffentlichungstag der Anmeldung: **09.09.1998**
(21) Anmeldenummer: 98100723.0
(22) Anmeldetag: 16.01.1998
(51) Int. Cl.: H01H 50/04, H05K 3/20

(54) **Leiterplatte für elektrische Schaltungen und Verfahren zur Herstellung einer solchen Leiterplatte**

(30) Priorität: 26.02.1997 DE 19707709
(71) Anmelder: SIEMENS AKTIENGESELLSCHAFT, 80333 München (DE)
(72) Erfinder: Tonejc, Vinko, 13469 Berlin (DE)

(57) **Zusammenfassung**

Die Leiterplatte (1) besteht aus einer Kunststoff-Trägerplatte (2) und einem die Leiterbahnen der elektrischen Schaltung bildenden einstückigen Stanzgitter (3), welche über vorzugsweise heißverprägte oder ultraschallverformte Kunststoffstege (12) mechanisch fest miteinander verbunden sind. Die Leiterbahnen weisen rechtwinklig abgebogene Anschluß-(3a) und Kontaktlappen (6) zur Kontaktierung des Stecksockels (4) und der aufzunehmenden Relais (10) sowie herausgeprägte Kontaktprofile (5) für die Verbindung mit elektrischen Bauteilen (11) auf. Die aufgesteckten Relais (10) und Bauteile (11) sind ebenso wie der Stecksockel (4) vorzugsweise durch Verschweißen lötfrei mit den Leiterbahnen verbunden. Durch Aussparungen (7) in der Trägerplatte (2) entsteht für Werkzeuge ein beidseitiger Zugang zu den Trennstellen (9) im Stanzgitter (3).

## Beschreibung

Die Erfindung betrifft eine Leiterplatte für eine elektrische Baugruppe, insbesondere für ein Relais-Modul für Kraftfahrzeuge, bestehend aus einer als Formteil aus Kunststoff gegossenen Trägerplatte und mit dieser verbundenen Leiterbahnen, welche von mindestens einem Stanzgitter gebildet sind, wobei in die Leiterplatte eingesteckte elektrische, insbesondere elektromechanische Bauelemente, wie Relais, über die Leiterbahnen elektrisch verbunden sind und die Trägerplatte Durchbrüche, welche sich direkt neben aus der Stanzgitterebene herausgebogenen Kontaktlappen befinden, zur Steckbefestigung von elektrischen Bauelementen aufweist. Außerdem betrifft die Erfindung ein Verfahren zur Herstellung einer derartigen Leiterplatte sowie eine Anordnung einer Leiterplatte auf einem Stecksockel.

Eine steckbare Baugruppe mit einer als Formteil aus Kunststoff gebildeten Leiterplatte, in die aus Stanzgittern gebildete Leiterbahnen eingebettet sind, ist aus DE 43 23 827 C1 bekannt. Dort sind auf der Leiterplatte über Leiterbahnen elektrisch verbundene Bauelemente befestigt, welche in Durchgangsöffnungen direkt neben den aus der Stanzgitterebene herausgebogenen Kontaktlappen eingesteckt werden. Das Herstellungsverfahren für die Leiterplatte gestaltet sich dadurch aufwendig, daß die Gewinnung der Leiterplatte durch Umspritzung der Stanzgitter in mehreren aufeinanderfolgenden Arbeitsgängen erfolgt, was nur bei großen Stückzahlen wirtschaftlich ist.

Aus der DE 27 35 124 A1 ist ein Verfahren zur Herstellung einer elektrischen Schaltung sowie eine nach dem Verfahren hergestellte Schaltungsplatte bekannt, wobei zunächst der der Schaltungsanordnung entsprechende Blechzuschnitt durch Stanzung aus dem Leitermaterial hergestellt wird und dieser anschließend in eine isolierende Kunststoffmasse eingeformt wird. Beim Einformen des Stanzgitters in die Kunststoffmasse werden beidseitige Aussparungen in der Kunststoffmasse zum Durchtrennen der Verbindungsstege vorgesehen. Im Anschluß an das Einformen des Stanzgitters in die Kunststoffmasse werden die Verbindungsstege unterbrochen. Nachteilig hierbei ist, daß die Anschlußdrähte der elektrischen Bauelemente angelötet werden, was dem Wunsch nach lötfreien Verbindungen in elektrischen Schaltungen mit Kontaktoberflächen enthaltenden Bauelementen entgegen steht. Des weiteren ist das Herstellungsverfahren unter Beachtung der notwendigen Fertigungstoleranzen für die Aussparungen und Durchbrüche technisch aufwendig.

In DE 89 12 914 U1 ist eine Leiteranordnung aus gestanzten Leiterbahnen beschrieben, wobei zusätzliche komplexe Schaltungsstrukturen realisierende Leiterbahnen durch Heißprägeverfahren auf den Leiterträger aufgebracht werden. Dabei werden die Leiterbahnen untereinander und mit den Bauelementen verlötet, um nicht die Struktur der geprägten Leiterbahnen durch Verschweißen zu schädigen. Eine derartige Leiteranordnung zur Unterbringung von mindestens zwei Relais nebst kundenspezifischer Verschaltung erfordert im Aufbau viele Einzelteile und wird daher nicht preiswert und automatisiert zu fertigen sein.

Ziel der Erfindung ist die preiswerte und mit einfachsten Werkzeugen und Hilfsmitteln zu realisierende automatisierte Fertigung einer Leiterplatte für elektrische Schaltungen derart, daß beispielsweise Relais und die die kundenspezifische Verschaltung enthaltene Leiterplatte in einem Gehäuse untergebracht werden können unter der Voraussetzung, die Schaltung mit sehr hohen Lastströmen betreiben zu können.

Erfindungsgemäß wird dies dadurch erreicht, daß die Leiterbahnen auf einer Seite der Trägerplatte angeordnet sind und durch verformte Kunststoffstege der Trägerplatte fixiert sind, und daß aus der Stanzgitterebene herausgebogene Anschlußlappen im Endbereich der Trägerplatte zur Kontaktierung mit Verbindungsleitern eines Stecksockels dienen.

Erfindungsgemäß ist somit die Lageanordnung der Leiterbahnen zur Trägerplatte durch die Kunststoffstege eindeutig festgelegt, wobei geeigneterweise das kundenspezifische Schaltbild soweit entflochten ist, daß ein Minimum an Stanzgittern notwendig ist, um die Leiterbahnen zu bilden.

In einer vorteilhaften Ausgestaltung sind die länglichen Kunststoffstege, welche zweckmäßigerweise mit abgerundeten Kanten versehen sind, zur weiteren Fixierung von Trägerplatte und Stanzgitter in Längs- und Querrichtung ausgebildet. Desweiteren kann die Trägerplatte im Bereich der Trennstellen des Stanzgitters Aussparungen für Trennwerkzeuge, insbesondere für Stanzwerkzeuge, enthalten, um diesen vorteilhafterweise beidseitige Zugänge zur Trennstelle zu eröffnen. Dadurch können beim Herstellungsverfahren die zur mechanischen Stabilisierung im Stanzgitter belassenen Verbindungsstege auf einfache Weise entfernt werden. Darüber hinaus können in Längs- und Querrichtung ausgebildete Anschläge sowie Führelemente für die Leiterbahnen, welche vorzugsweise von einem einteiligen Stanzgitter gebildet sind, in die Trägerplatte integriert sein, um damit eine einfache und toleranzarme Anordnung von Trägerplatte und Leiterbahnen zueinander zu ermöglichen. Speziell ist hierbei eine Kombination von Anschlag und Führelement als weitere Ausgestaltung sinnvoll, wobei das Führelement in Form einer Führnase in den Anschlag eingebunden wird.

Ferner können die Leiterbahnen in Nuten der Kunststoff-Trägerplatte versenkt untergebracht und durch verformte Randbereiche der Nuten befestigt sein. Dies stellt eine alternative Ausgestaltungsmöglichkeit der erfindungsgemäßen Leiterplatte dar, wobei sowohl auf die Kunststoffstege zur Befestigung als auch auf die Anschläge und Führelemente zur Ausrichtung der Leiterbahnen verzichtet werden kann, da diese Merkmale funktionell durch die Nuten einschließlich der deformierten Randbereiche zusammengefaßt werden. Des weiteren dienen die Nuten durch Ausfüllen der Räume zwischen benachbarten Leiterbahnen zu deren Isolierung.

Zudem sorgen speziell an die Form der aufgesteckten Bauelemente angepaßte Auflageflächen der Trägerplatte für einen verbesserten Sitz der Bauelemente, insbesondere der schwereren Relais, auf der Leiterplatte. Alternativ sind für Bauelemente, die hinsichtlich ihres Gewichtes keine Handhabungsprobleme bei der Montage bereiten, spezielle Halterungen in der Trägerplatte vorgesehen, in die die entsprechenden Bauelemente einfach eingesteckt sind. Die Anschlußelemente dieser Bauelemente sind auf herausgeprägten Kontaktprofilen der Leiterbahnen vorzugsweise durch Widerstandsschweißung befestigt. Zweckmäßigerweise können die Steckanschlüsse der übrigen Bauelemente mit den Kontaktlappen der Leiterplatte zur Erhöhung der mechanischen Festigkeit und zur Verbesserung der elektrischen Leitfähigkeit ebenfalls verschweißt sein.

Beim Verfahren zur Herstellung der erfindungsgemäßen Leiterplatte wird zunächst die Tägerplatte mit den genannten Merkmalen als Formteil aus Kunststoff gegossen. Die Leiterbahnen werden vorzugsweise zeitgleich in Form eines einstückigen Stanzgitters aus dem Leiterblech ausgeschnitten, wobei zur Verbesserung der Handhabung und der mechanischen Festigkeit Verbindungsstege im Bereich von Trennstellen im Stanzgitter belassen werden. Im nächsten Herstellungsschritt erfolgt die Verbindung von Trägerplatte und Stanzgitter zur Leiterplatte. Dabei wird einfach das Stanzgitter auf die Trägerplatte gelegt. Dann wird das Stanzgitter zunächst in Quer-, dann in Längsrichtung gegen die auf der Trägerplatte ausgebildeten Anschläge geschoben. Führelemente der Trägerplatte können den Ausrichtvorgang dadurch unterstützen, daß sie die Anordnung in zumindest einer Richtung fixieren. In der endgültigen Anordnung ausgerichtet werden Stanzgitter und Trägerplatte durch Verformen der Kunststoffstege oder der Nutrandbereiche, vorzugsweise mittels Heißstempelverprägens oder Ultraschallverformens, fest miteinander verbunden. Über die Aussparungen der Trägerplatte im Bereich der Trennstellen des Stanzgitters werden die Verbindungsstege vorzugsweise durch einen Stanzschnitt entfernt, so daß die endgültige Schaltungstopologie entsteht. Im Anschluß daran werden die Bauelemente mit ihren Anschlußelementen in die erzeugte Leiterplatte eingesteckt und vorzugsweise durch Anschweißen mit den Leiterbahnen kontaktiert.

Gerade bei der Fertigung von Leiterplatten in geringen Stuckzahlen ist das Verfahren zur Herstellung der beschriebenen Leiterplatte vorteilhaft, da sich der Herstellungsprozeß im Vergleich zum Einformen von Leiterbahnen oder Blechzuschnitten in Kunststoff in geringer Zeit und mit geringem Hilfsmittel- und Werkzeugaufwand gestalten läßt. Zudem wird bei diesem Herstellungsverfahren dem Wunsch nach lötfreien elektrischen Verbindungen in elektrischen Schaltungen mit Schaltkontakten auf vorteilhafte Weise Rechnung getragen.

Bei der Anordnung der erfindungsgemäßen Leiterplatte auf einem Stecksockel ist die Leiterplatte senkrecht zur Hauptebene des Stecksockels in dessen Randbereich angeordnet. Durch die Verbindung der Anschlußlappen des Stecksockels mit denen der Leiterplatte ist die gesamte Anordnung befestigt. Große Bauelemente, wie Relais, sind auf der dem Stecksockel zugewandten Seite der Leiterplatte angebracht, so daß beispielsweise noch eine Kappe über die Leiterplatte gestülpt sein kann, welche zusammen mit dem Sockel ein Gehäuse bildet. In einer vorteilhaften Ausgestaltung dieser Anordnung sind die Lastanschlüsse der Bauelemente, insbesondere der Relais, direkt über den Stecksockel kontaktiert, während die Steueranschlüsse mit der Leiterplatte verbunden sind.

Die Erfindung wird nachfolgend an Ausführungsbeispielen anhand der Zeichnung näher erläutert. Es zeigt
Fig. 1 eine erfindungsgemäß gestaltete Leiterplatte, bestückt mit zwei Relais, zwei Widerständen und einem angeschweißten Stecksockel in perspektivischer Darstellung,
Fig. 2 die in Fig. 1 dargestellte Leiterplatte in der Draufsicht,
Fig. 3 die Bestandteile der Leiterplatte vor dem Verformen der Kunststoffstege und dem Anschweißen der elektrischen Bauteile und
Fig. 4 die in Fig. 1 dargestellte Leiterplatte in der Seitenansicht.

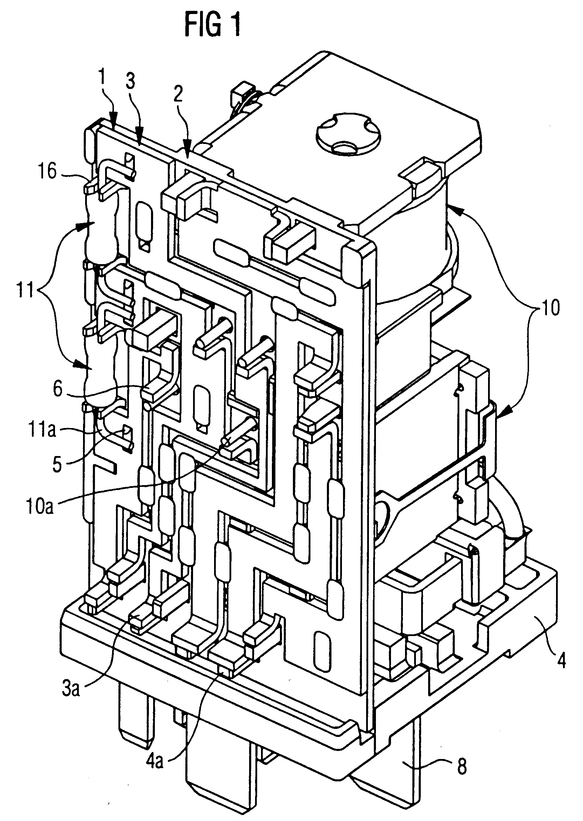

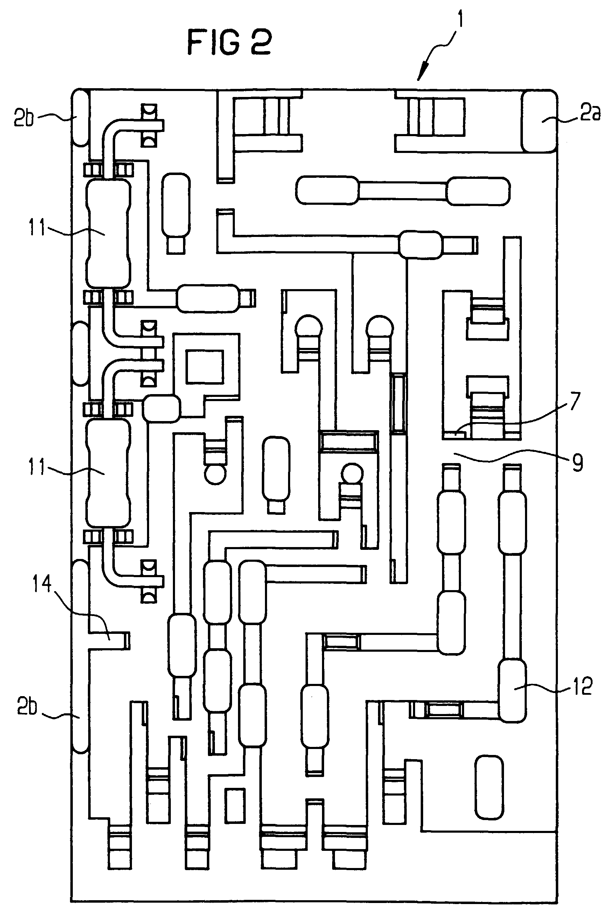

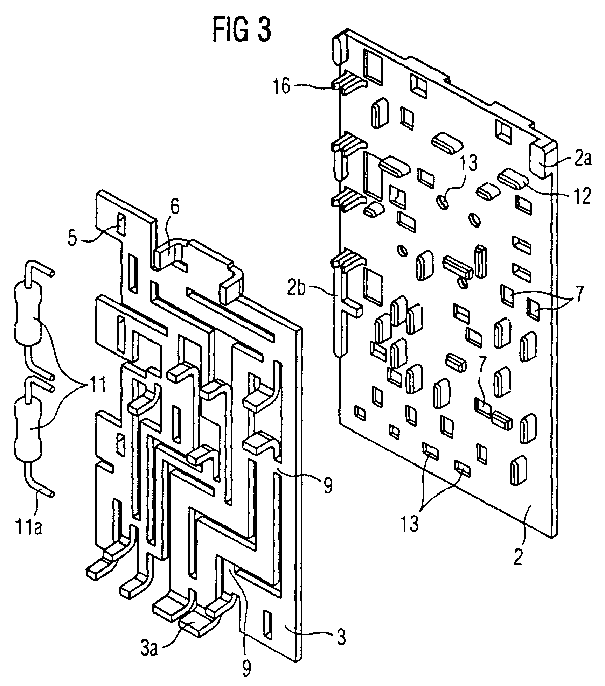

Die in den Fig. 1 und 2 dargestellte Leiterplatte 1, welche aus einer Kunststoff-Trägerplatte 2 und in einer Ebene angeordneten Leiterbahnen besteht, ist mit zwei Relais 10 sowie zwei elektrischen Bauteilen 11 bestückt. Die aus der Trägerplatte 2 hervorstehenden verformten Kunststoffstege 12, von denen sich einige in Längs- und andere in Querrichtung erstrecken, sorgen für die allseitige Fixierung der von einem Stanzgitter 3 gebildeten Leiterbahnen auf der Trägerplatte 2. Um Stanzwerkzeugen einen beidseitigen Zugang zu den Trennstellen 9 im Stanzgitter 3 zu eröffnen, sind im gegenüberliegenden Bereich auf der Trägerplatte 2 Aussparungen 7 vorgesehen (siehe Fig. 2 und Fig. 3). Zur einfachen und schnellen Ausrichtung von Trägerplatte 2 und Stanzgitter 3 sind Anschläge 2a, 2b in Längs- und Querrichtung ausgebildet. Des weiteren ist ein zusätzliches Führelement 14 in Form einer Führnase in einen Anschlag 2b integriert, welches für eine weitere Fixierung des Stanzgitters 3 auf der Trägerplatte 2 in Längsrichtung der Leiterplatte 1 sorgt (Fig. 2).

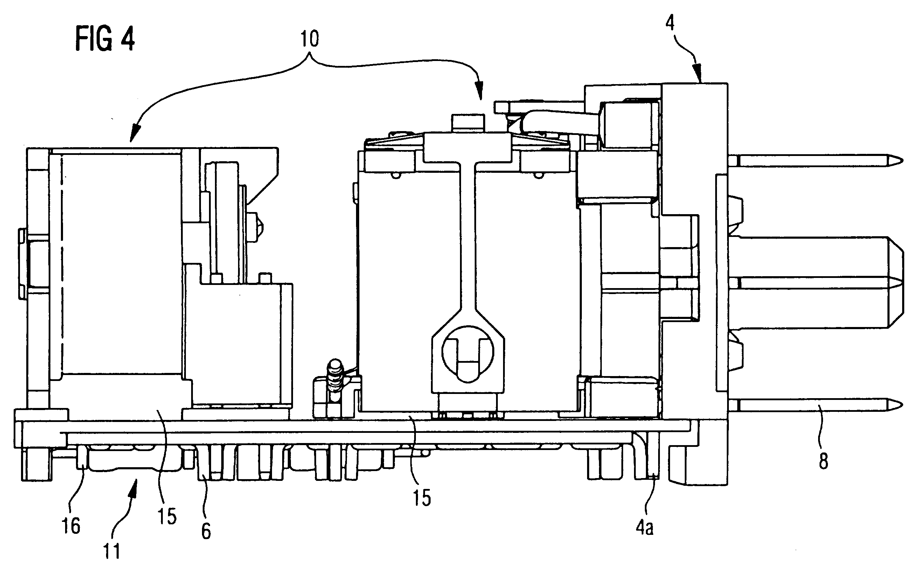

Außerdem sind in der Trägerplatte 2 noch Auflageflächen 15 für Relais 10 ausgeformt, um deren Halterung auf der Leiterplatte 1 zu verbessern (Fig. 4). Bauelemente 11 mit geringem Gewicht sind lediglich in entsprechende Halterungen 16 der Trägerplatte 2 eingesetzt, und ihre Anschlußelemente 11a sind an speziell dafür vorgesehenen Kontaktprofilen 5, welche von der Rückseite des Stanzgitters 3 herausgeprägt sind, mit den Leiterbahnen verschweißt, wodurch eine ausreichende Abreißfestigkeit gegeben ist (siehe Fig. 1 und Fig. 3). Zur Aufnahme der Anschlußelemente 10a der Relais 10 sind in der Trägerplatte 2 Durchbrüche 13 vorgesehen, welche sich unmittelbar neben den rechtwinklig aus dem Stanzgitter 3 herausgebogenen Kontaktlappen 6 befinden. Die Kontaktlappen 6 sind mit den Anschlußelementen 10a verschweißt und dienen dadurch der Kontaktierung der Relais 10 mit den Leiterbahnen (Fig. 1).

Die Herstellung der Leiterplatte 1 läßt sich in wenigen Arbeitsschritten und mit einfachen Werkzeugen gestalten. Nach Erzeugung der Trägerplatte 2 durch Formgießen aus Kunststoff und des Stanzgitters 3 durch Blechzuschnitt aus dem Leitermaterial wird das Stanzgitter 3 auf die Seitenoberfläche der Trägerplatte 2 gelegt. Anschließend wird das Stanzgitter 3 in Querrichtung bis an die Anschläge 2b der Trägerplatte 2 verschoben. Danach erfolgt die Ausrichtung in Längsrichtung, welche durch die Anschläge 2a bestimmt wird. Durch ein Führelement 14, welches in einen Anschlag 2b integriert ist, wird die Anordnung in Längsrichtung fixiert. Daneben verhindern in Längs- und Querrichtung ausgebildetete Kunststoffstege 12 das Verücken des Stanzgitters 3 auf der Trägerplatte 2. Nachdem die Kunststoffstege 12 mittels Heißverprägens oder Ultraschallverformen verformt worden sind, entsteht die Leiterplatte 1 als feste Einheit von Trägerplatte 2 und Stanzgitter 3. Im letzten Herstellungschritt werden die im einstückigen Stanzgitter 3 belassenen Verbindungsstege durch einen Stanzschnitt an den Trennstellen 9 entfernt, so daß die endgültige Schaltungstopologie entsteht.

In Fig. 1 und Fig. 4 ist eine Anordnung einer bestückten Leiterplatte 1 auf einem an der Unterseite senkrecht zur dieser stehenden Stecksockel 4 dargestellt. An der Unterseite des Stecksockels 4 sind rechtwinklig heraustretende Flachstecker 8 angebracht. Die Kontaktierung der Leiterplatte 1 mit dem Stecksockel 4 erfolgt über die jeweils zugeordneten Anschlußlappen 3a und 4a. Wie in Fig. 4 zu sehen ist, sind die Anschlußlappen 4a des Sockels 4 durch entsprechende Durchbrüche 18 in der Trägerplatte 2 geführt, welche sich direkt neben den Anschlußlappen 3a der Leiterplatte 1 befinden. Die gewünschte elektrische Leitfähigkeit sowie die erforderliche mechanische Festigkeit der Verbindung zwischen Leiterplatte 1 und Stecksockel 4 ist durch die Verschweißung der Anschlußlappen 3a und 4a gegeben. In der endgültigen Ausgestaltung kommt noch ein die genannten Baugruppen einschließendes Gehäuse hinzu, welches hier nicht explizit dargestellt ist.

Die dargestellte Konfiguration der Leiterplatte ist als Beispiel anzusehen, da auch Bestückungsvarianten mit mehr als zwei Relais denkbar sind, sofern dadurch die Randbedingung nicht verletzt wird, daß sich die Leiterplatte nebst Bestückung und Sockel in einem Gehäuse unterbringen läßt, was angesichts des Trends zu immer kleineren Relaisbauformen bei steigenden Lastströmen realistisch erscheint. Nach dem Stanzverfahren hergestellte Leiter, die bei geeigneter Entflechtung der Schaltungstopologie die Unterbringung der einzelnen Leiterbahnen in einem einstückigen Stanzgitter ermöglichen, sind zwar weniger für die Realisierung komplexer Schaltungsstrukturen geeignet, jedoch in Schaltungen, durch welche größere elektrische Leistungen gesteuert werden, weiterhin vorteilhaft, zumal sie durch die Auswahlmöglichkeit von Leitermaterial und -stärke eine Anpassung an das jeweilige Anwendungsgebiet ermöglichen.

## Patentansprüche

1. Leiterplatte für eine elektrische Baugruppe, insbesondere für ein Relais-Modul für Kraftfahrzeuge, bestehend aus einer als Formteil aus Kunststoff gegossenen Trägerplatte (2) und mit dieser verbundenen Leiterbahnen, welche von mindestens einem Stanzgitter (3) gebildet sind, wobei in die Leiterplatte (1) eingesteckte elektrische, insbesondere elektromechanische Bauelemente (10, 11), wie Relais, über die Leiterbahnen elektrisch verbunden sind und die Trägerplatte (2) Durchbrüche (13), welche sich direkt neben aus der Stanzgitterebene herausgebogenen Kontaktlappen (6) befinden, zur Steckbefestigung von elektrischen Bauelementen (10, 11) aufweist,
**dadurch gekennzeichnet,** daß die Leiterbahnen auf einer Seite der Trägerplatte (2) angeordnet sind und durch verformte Kunststoffstege (12) der Trägerplatte fixiert sind, und daß aus der Stanzgitterebene herausgebogene Anschlußlappen (3a) im Endbereich der Trägerplatte (2) zur Kontaktierung mit Verbindungsleitern eines Stecksockels (4) dienen.

2. Leiterplatte nach Anspruch 1,
**dadurch gekennzeichnet,** daß die Trägerplatte (2) im Bereich von Trennstellen (9) des Stanzgitters (3) Aussparungen (7) für Trennwerkzeuge aufweist.

3. Leiterplatte nach Anspruch 1 oder 2,
**dadurch gekennzeichnet,** daß auf der Trägerplatte (2) Anschläge (2a, 2b) in Längs- und Querrichtung sowie Führelemente (14), insbesondere in Form von in die Anschläge (2a, 2b) integrierten Führnasen, zur Ausrichtung der Leiterbahnen ausgebildet sind.

4. Leiterplatte nach einem der Ansprüche 1 bis 3,
**dadurch gekennzeichnet**, daß das die Leiterbahnen bildende Stanzgitter (3) in Nuten der Trägerplatte (2) versenkt angeordnet ist und durch deformierte Randbereiche der Nuten fixiert ist.

5. Leiterplatte nach einem der Ansprüche 1 bis 4,
**dadurch gekennzeichnet**, daß die Trägerplatte (2) Auflageflächen (15) und Halterungen (16) zur Aufnahme elektrischer Bauelemente (10, 11) besitzt.

6. Leiterplatte nach einem der Ansprüch 1 bis 5,
**dadurch gekennzeichnet,** daß zur Kontaktierung elektrischer Bauelemente (10, 11) auf den Leiterbahnen herausgeprägte Kontaktprofile (5) zum Befestigen von Anschlußelementen (10a, 11a) der Bauelemente (10, 11) ausgebildet sind.

7. Leiterplatte nach einem der Ansprüche 1 bis 6,
**dadurch gekennzeichnet,** daß die auf der Trägerplatte (2) ausgeformten länglichen Kunstoffstege (12) zur Fixierung der Leiterbahnen sowohl in Längs- als auch in Querrichtung ausgebildet sind.

8. Leiterplatte nach einem der Ansprüche 1 bis 7,
**dadurch gekennzeichnet,** daß die elektrischen Bauelemente (10, 11) lötfreie Verbindungen zu den Leiterbahnen besitzen.

9. Verfahren zur Herstellung einer Leiterplatte nach einem der Ansprüche 1 bis 8,
**dadurch gekennzeichnet,** daß eine Trägerplatte (2) als Formteil aus Kunststoff mit zumindest auf einer Seite angeordneten Kunststoffstegen (12) hergestellt wird, daß Leiterbahnen mit Verbindungsstegen aus einer Blechplatine in Form eines einstückigen Stanzgitters (3) ausgeschnitten werden, daß das Stanzgitter (3) auf die Trägerplatte (2) gelegt und durch Verformung der Kunststoffstege (12) fixiert wird, und daß die Verbindungsstege im Bereich von Trennstellen (9) unterbrochen werden.

10. Verfahren Leiterplatte nach Anspruch 9,
**dadurch gekennzeichnet,** daß in die Trägerplatte (2) Aussparungen (7) im Bereich der Trennstellen (9) des Stanzgitters (2) eingeformt werden, und daß die Verbindungsstege mittels durch die Aussparungen (7) greifender Trennwerkzeuge entfernt werden.

11. Verfahren nach Anspruch 9 oder 10,
**dadurch gekennzeichnet,** daß Anschlußelemente (10a, 11a) elektrischer Bauelemente (10, 11) in Durchbrüche (13) der Trägerplatte (2) eingesteckt werden und mit aus der Hauptebene des Stanzgitters (3) herausgebogenen Kontaktlappen (6), welche sich direkt neben den Durchbrüchen (13) befinden und unmittelbar an den Anschlußelementen (10a, 11a) anliegen, verschweißt werden.

12. Anordnung einer Leiterplatte nach einem der Ansprüche 1 bis 8 auf einem Stecksockel,
**dadurch gekennzeichnet,** daß die Leiterplatte (1) senkrecht zur Hauptebene des Stecksockels (4) in dessen Randbereich angeordnet ist und durch Verbindung von Anschlußlappen (3a) der Leiterplatte (1) mit den Verbindungsleitern des Sockels (4) befestigt ist, wobei auf der dem Sockel (4) zugewandten Seite der Leiterplatte (1) mindestens ein Relais (10) sowie weitere elektrische Bauelemente (11) angeordnet sind.

13. Anordnung nach Anspruch 12,
**dadurch gekennzeichnet,** daß die elektrischen Bauelemente (10, 11), insbesondere die Relais (10) mit Steueranschlüssen über die Leiterplatte (1) und mit Lastanschlüssen direkt über den Stecksockel (4) kontaktiert sind.
